Europäisches Patentamt

European Patent Office

Office européen des brevets

(11) Publication number: **0 086 410**
**B1**

(12) EUROPEAN PATENT SPECIFICATION

(45) Date of publication of patent specification: **04.09.85**

(21) Application number: **83101043.4**

(22) Date of filing: **04.02.83**

(51) Int. Cl.⁴: **G 03 F 7/20, H 05 K 3/00**

(54) Apparatus and method for exposing a substrate.

(30) Priority: **08.02.82 US 346752**

(43) Date of publication of application:
**24.08.83 Bulletin 83/34**

(45) Publication of the grant of the patent:
**04.09.85 Bulletin 85/36**

(84) Designated Contracting States:
**DE FR GB**

(56) References cited:
**DE-A-2 048 471**
**DE-A-2 603 879**
**FR-B-2 252 800**
**FR-B-2 269 845**
**US-A-3 761 264**

**IBM TECHNICAL DISCLOSURE BULLETIN, vol.
7, no. 7, December 1964, pages 616-617, New
York, USA A. ROTHAUSER: "Step and repeat
contact printer"**

(73) Proprietor: **E.I. DU PONT DE NEMOURS AND
COMPANY**
**1007 Market Street**
**Wilmington Delaware 19898 (US)**

(72) Inventor: **Waddington, Marvin, Jr.**
**1512 Sheldon Drive**
**Newark Delaware 19711 (US)**

(74) Representative: **Werner, Hans-Karsten, Dr. et al**
**Deichmannhaus am Hauptbahnhof**
**D-5000 Köln 1 (DE)**

## Description

Background of the invention

This invention relates to an apparatus and a method for exposing a substrate having a photopolymerizable coating thereon by means of a substantially perpendicularly beam of UV-radiation.

Circuit boards used in the electronics industry typically comprise a substrate having a conductive copper layer formed thereon. In order to form conductor patterns on the surface of the board it is common practice first to coat the board with a photopolymerizable coating of a material known as a photoresist, such as the photopolymer resist sold by E. I. du Pont de Nemours and Company under the trademark "Riston". The coating is usually laminated onto the surface of the board by the use of pressure and heat.

The circuit board having the coating laminated thereon is supported on a frame and a mask or "phototool" is placed thereover. The board is thereafter exposed to actinic radiation, commonly ultraviolet light, through the phototool. The phototool is disposed in close contact with the surface of the circuit board by drawing a vacuum within the frame. Opaque areas in preselected portions of the phototool shield or prevent the incidence of radiation onto corresponding areas of the coating over which the tool lies.

Those portions of the coating onto which actinic radiation is permitted to fall through the open areas of the phototool become polymerized. The shielded or unexposed areas remain in the nonpolymerized state and may be removed from the board by known techniques, e.g., by developing or washing the nonpolymerized material using known developing chemistry. Thereafter, various etching or layering techniques may be utilized to either remove or add material to the portions of the copper surface unprotected by polymerized resist to form the conductor patterns on the board.

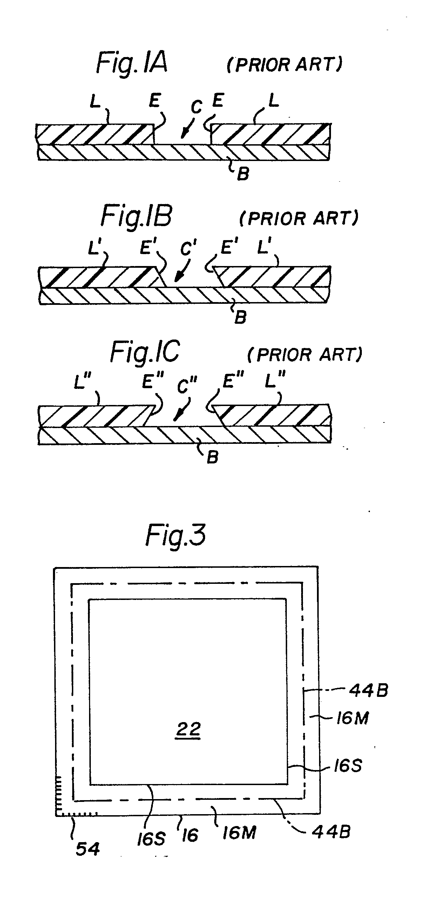

The source of actinic radiation used in the above-described process may be considered as a point source lying vertically above and substantially centrally of the surface of the circuit board. Actinic radiation emitted from the source propagates radially outwardly therefrom and toward the planar surface of the circuit board. Radiation from the source impinges substantially perpendicularly onto the portion of the surface of the board lying directly vertically below the point source. As a result, the vertical edges of the polymerized portions of the resist in this region of the board are substantially vertically inclined with respect to the surface of the board. This condition is illustrated in Figure 1A. There, in an edgewise cross-section of the board B, adjacent lines L of polymerized resist material exhibit substantially vertical edges E. As a result the distance between adjacent confronting edges E is farily uniform. Further, the channel C defined by the surface of the board B and confronting edges E of the polymerized resist lines L is rectangular in the edgewise view shown in Figure 1A.

However, as one proceeds along the surface of the board radially from the vertical centerline (VCL) thereof actinic radiation from the point source impinges onto the board at an angle with respect to the vertical. As a result, as illustrated in Figure 1B, the edges E' of the polymerized lines L' in these regions of the board are inclined with respect to the vertical. The channels C' so formed are trapezoidal in the edgewise view shown in Figure 1B.

The source of actinic radiation is surrounded by a parabolic reflective hood. It has been observed that as a result of reflections from the hood the edges E" of adjacent lines L" on some areas of the board are undercut, as shown in Figure 1C. In these instances the channels C" between adjacent lines L" are in the shape of inverted trapezoids when viewed edgewise.

In order to avoid the condition shown in Figures 1B and 1C attempts have been made to collimate light emitted from the point source of actinic radiation so that the radiation impinges the surface of the board B substantially perpendicuarly thererto. One such prior art technique utilizes a conical head coated with a reflective material partially surrounding the source of actinic radiation. As a result, a portion of the radiation emitted from the source toward the hood is reflected thereby and directed toward the board in substantially parallel ray paths. This system is believed disadvantageous, however, because it does not completely eliminate radiation striking the board at angles to the vertical, and thus lines L' as shown in Figure 1B are still formed.

As another alternative a device known as an "eggcrate" reflector is disposed intermediate the point source and the frame. The eggcrate reflector serves to channelize radiation passing through each cell of the reflector and therbey partially collimate and direct the light toward the board so as to strike the board substantially perpendicularly thereto. This expedient is also believed disadvantageous because of the energy losses associated with the collimating action of the eggcrate reflector.

Further, various mirror arrangements have also been devised whereby the light emitted from a source of radiation is redirected so as to impinge upon the surface of the board in a direction substantially perpendicularly thereto. However, these reflective arrangements are believed disadvantageous because they result in a relatively low light intensity at the surface of the board, thus requiring a commensurately greater energy input to the source.

In view of the foregoing it is believed advantageous to provide an imaging system and a method for exposing circuit board to actinic radiation whereby light emitted from the source of actinic radiation is caused to impinge upon the entire surface of the circuit board substantially perpendicularly thereto. It is also believed advantageous to achieve such a condition with the minimum loss of available radiation energy so that board exposure time and energy expenditure requirements may be lessened.

From FR—A—2 252 800 it is known to collimate the radiation by an optical lens. There is, however, no indication what kind of lens has been used. For the collimation of UV-radiation the experts, however, avoided to use a normal optical lens because nearly all usual glasses have a relatively high adsorption for UV-radiation, which leads to high losses of the radiation and a severe heating of the lens from the adsorpted part of the radiation. The experts, therefore, preferred conical heads, eggcrate reflectors and mirror arrangements and tried to avoid optical lenses at all. The only material which has very low adsorption of UV-radiation is pure $SiO_2$. Lenses from this material, however, are extremely expensive, especially if the diameter and the thickness extends the dimensions of mm.

Lenses of higher diameters and the thickness of cm, therefore, are available only from optical glasses which, however, have the disadvantage of a relatively high adsorption of the UV-light. Even if the problem of the losses of radiation and the creation of heat might be acceptable and could be solved by a good ventilation, such lenses have a further severe disadvantage, which makes them unacceptable for the purpose of exposing a substrate having a photopolymerizable coating thereon: As the way of the radiation through the lens is much longer than the centre of the lens then the outer areas thereof, the radiation is considerably weaker in the centre than in the outer areas. For the photopolymerization of the substrate, however, it is demanded to have a radiation of approximately the same strength in all areas. This only could be solved in the past by avoiding lenses at all and using other optical means like conical heads, eggcrate reflectors, mirror arrangements etc.

Fresnel lenses normally are used only for spotlights and in certain cases for a focusing screen, distributing the image brightness over the area. It was known, however, that fresnel lenses are not used for an exact collimation of radiation. They were not used up till now for the collimation of UV-radiation.

It now was found that fresnel lens being greater than the area of the frame to be exposed can be used and shows excellent results.

The invention, therefore, relates to an apparatus for exposing a substrate having a photopolymerizable coating thereon, the apparatus being of the type having a support frame for supporting the member thereon, a source of actinic UV-radiation disposed above the support frame and a lens disposed intermediate the source of actinic radiation and the support frame, the lens being adapted to collimate radiation emitted from the source and direct the radiation toward the support frame such that radiation from the source impinges onto member in a direction substantially perpendicularly thereto over the entire surface area thereof, characterized in that the lens is a fresnel lens and the area of the fresnel lens is greater than the area of the frame.

Furtheron, this invention relates to a method for exposing a substrate having a photopolymerizable coating thereon comprising the steps of:

mounting the substrate in a location in the beam path of a source of actinic UV-radiation;

interposing a lens in the beam path such that radiation from the source is able to be collimated by the lens into a direction substantially perpendicular to the substrate;

activating the source to illuminate the substrate through the lens, characterized in that the lens is a fresnel lens and the area of the fresnel lens is greater than the area of the frame.

The apparatus according to the invention therefore includes a support surface, a frame, for mounting circuit board having a coating of photopolymerizable material thereon in a supported relationship in the ray path of a source of actinic radiation. The frame is preferably disposed vertically beneath the source of actinic radiation. Disposed in the ray path intermediate the source of actinic radiation and the frame is a fresnel lens. The fresnel lens is adapted to collimate radiation emitted from the source and direct the radiation in substantially parallel ray paths toward the surface of the circuit board so as to strike the same in a substantially perpendicular direction over the entire surface area thereof. The fresnel lens is disposed above in vertical registration with the frame. The plane of the fresnel lens is parallel to the plane of the frame. The area of the lens is greater than the area of the frame so that the frame is completely shadowed by and lies within the boundaries of the lens.

Brief description of the drawings

The invention will be more fully understood from the following detailed description thereof, taken in connection with the accompanying drawings, which form part of this application and in which:

Figures 1A, 1B and 1C are side elevational views entirely in section of photopolymerized lines on the surface of a circuit board in which the photopolymerizable coating on the board is exposed utilizing exposure units of the prior art;

Figure 2 is a highly stylized side elevational view of a photoimaging system in accordance with the instant invention; and

Figure 3 is a plan view of a photoimaging system shown in Figure 2 taken along view lines 3—3.

Detailed description of the invention

Throughout the following detailed description similar reference numerals refer to similar elements in all figures of the drawings.

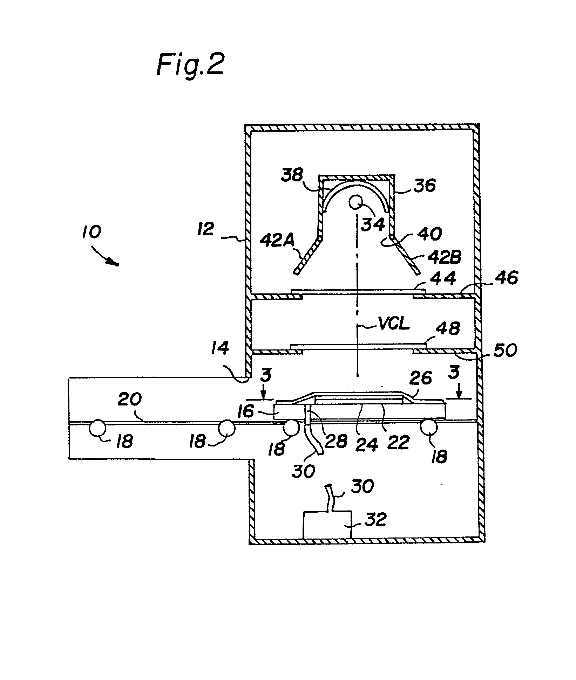

With reference now to Figures 2 and 3 shown is a photoimaging and exposure unit generally indicated by reference character 10 in accordance with the instant invention. The unit 10 includes a substantailly light tight housing 12 having an access aperture 14 disposed in one sidewall thereof. A support surface or frame 16 is adapted for movement into and out of the interior of the housing 12 on roller elements 18 and guide rails 20 conveniently disposed within the housing 12. Some exposure apparatus, such as that sold by E. I. du Pont de Nemours and Company under the name PC-30 is configured with dual frames which are alternately movable into the housing 12. However, such a dual frame arrangement is omitted from the Figure for clarity of illustration.

The frame 16 includes a portion 16S (Figure 3) on the planar surface thereof which receives and supports planar printed circuit boards 22 on which a photopolymerizable layer has been provided. A phototool 24 having opaque and transparent regions thereon corresponding to a conductor pattern is disposed over the board 22.

A transparent shroud 26 is provided on the frame 16 for a purpose discussed herein. A vacuum port 28 is provided in the frame 16. The port 28 is connected by a suitable aspiration line 30 to a vacuum pump 32 for a purpose to be discussed herein.

On the interior of the housing 12 substantially along the vertical centerline VCL thereof is a source 34 of actinic radiation. The source 34 is mounted within a housing 36 secured to the interior of the housing 12. Suitable for use as the source 34 is a 5000 watt ultraviolet light such as that manufactured and sold by Wilhelm Staub GmbH under the name Ultralux. The housing 36 also contains a parabolic reflector 38 arranged to direct radiation emitted from the source 34 out of the housing 36 through an aperture 40. The aperture 40 is controllably closable by shutters 42A and 42B. It is to be understood that although the source 34 is in actuality slightly elongated the source 34 generally may be regarded as emitting actinic radiation in the manner of a point source.

A fresnel lens 44 is mounted within the housing 12 intermediate the source 34 and the frame 16 on a suitable mounting bracket 46. The bracket 46 is arranged within the housing 12 in any convenient manner. Any fresnel lens exhibiting the appropriate focal length for the wavelength of actinic radiation and compatible with the physical arrangement of the structural elements of the exposure unit 10 may be used. The fresnel lens 44 is mounted within the ray path of the source 34 with the planar surface of the lens 44 lying substantially parallel to the surface of the support frame 16. A heat baffle 48 may be supported on a suitable mounting bracket 50 conveniently arranged within the housing, if desired. It should be noted that some exposure units, such as the exposure apparatus referred to earlier, may be provided with a second source disposed in a housing below the frame. Of course, if more than one source is provided, a fresnel lens may be mounted in the ray path thereof intermediate the source and the board in accordance with the teachings of this invention as herein set forth.

As seen in Figure 3 the area of the fresnel lens 44 is greater than the area of the supporting portion 16S of the frame 16. That is, the boundaries 44B of the area of the fresnel lens 44 (shown by dot-dash lines in Figure 3) overshadows and vertically registers with that portion 16S of the frame 16 which supports the circuit board 22. In addition, the boundaries of the lens 44 also vertically overshadows a portion of the marginal region 16M of the frame which surrounds the supporting region 16S thereof.

In operation, with the frame 16 supported on the rollers 18 and with the guide 20 disposed outside the housing 12 a circuit board 22 is mounted onto the support portion 16S of the frame 16. Suitable indica 54 (Figure 3) are provided for appropriately centering the board 22 within the support portion 16S of the frame. Thereafter, the phototool 24 (Figure 2) whose pattern is to be exposed onto the surface of the board 22 is placed directly thereover. With the shroud 26 covering both the board 22 and the phototool 24 the frame 16 is inserted into the casing 12. When in the casing 12 it is noted that the vertical centerline VCL defines an axis of symmetry for the support surface 16S of the frame 16, for the fresnel lens 44, and for the source 34.

Once the frame 16 is inserted into the casing 12 the pump 32 is actuated therbey pulling a vacuum in that region beneath the shroud 26. The phototool 24 is thus drawn into intimate contact with the surface of the printed circuit board 22. Thereafter, the light source 34 is activated and the board 22 is illuminated by actinic radiation through the lens 44.

Due to the action of the fresnel lens 44 actinic radiation radiating from the source 34, shown by the reference character 56, is collimated by the lens 44 and directed in subtantially parallel ray paths 58 toward the entire surface of the board 22 supported on the frame 16. As a result actinic radiation impinges upon the surface of the frame 16 substantially perpendicuarly to the surface thereof. Since the radiation impinges perpendicuarly to the surface of the board 22 it has been observed that polymerized lines L, when viewed edgewise in any region of the board 20, appear similar to those obtained only in the region directly beneath the source of actinic radiation in prior art exposure units (Figure 1A).

Also as a result of the utilization of the fresnel lens 44 is has been observed that the energy levels of radiation impinging upon the surface of the circuit board have been increased.

Using an exposure apparatus and a radiation source as described above, the energy level at the surface of a board was measured at predetermined locations across the entire surface of the support frame using an IL-700 (International Light) radiometer with an SC-140B detector. The incident energy levels in units of millijoules per square centimeter noted in the left hand column of the Table were recorded. With a 45,7 cm focal length fresnel lens manufactured by Edmund

7

0 086 410

8

Scientific Inc. support 45,7 cm from the source the incident energy levels at the same points were recorded, as noted in the right hand column of the Table. In both instances the exposure time was ten seconds.

TABLE

| Incident Energy (mJ/cm²) without fresnel lens | Incident energy (mJ/cm²) with fresnel lens |
|---|---|
| 47.9 | 108.8 |
| 64.1 | 112.4 |
| 70.6 | 107.1 |
| 53.7 | 123.0 |
| 56.6 | 97.5 |
| 69.4 | 94.3 |
| 76.8 | 100.7 |
| 62.8 | 103.6 |
| 55.0 | 90.4 |
| 65.3 | 96.3 |
| 69.6 | 106.9 |
| 61.7 | 100.2 |

It may be observed from the Table that an increase in incident energy onto the surface of the circuit board was observed when the fresnel lens was interposed in the ray path from the source to the frame.

The increase in energy is believed caused by the collecting and collimating action of the fresnel lens 44. In the instance of a point light source without a fresnel lens, radiation may be envisioned as emanating radially in all directions from the source. As a result certain of the beams propagate in radial ray paths and do not impact upon the board. Moreover, those radiation beams which do impinge upon the board generally do so at an inclined angle (Figure 1B). However with the provision of a fresnel lens 44 interposed above the board in the ray path intermediate the board and the source radiation which would otherwise miss the board is directed toward the board so as to impinge thereon. This is believed to cause the increase in the available energy impinging upon the board. As a result of the increased energy incident onto the board exposure times may be decreased (assuming the same source intensity) or, conversely, source intensity may be decreased for comparable exposure times.

## Claims

1. Apparatus (10) for exposing a substrate (22) having a photopolymerizable coating thereon, the apparatus being of the type having a support frame (16) for supporting the member thereon, a source of actinic UV-radiation (34) disposed above the support frame (16)
and a lens (44) disposed intermediate the source of actinic radiation (34) and the support frame (16), the lens (44) being adapted to collimate radiation emitted from the source (34) and direct the radiation toward the support frame (16) such that radiation from the source impinges onto member in a direction substantially perpendicularly thereto over the entire surface area thereof, characterized in that the lens (44) is a fresnel lens and the area of the fresnel lens is greater than the area of the frame.

2. A method for exposing a substrate (22) having a photopolymerizable coating thereon comprising the steps of:
mounting the substrate (22) in a location in the beam path of a source of actinic UV-radiation (34);
interposing a lens (44) in the beam path such that radiation from the source is able to be collimated by the lens into a direction substantially perpendicular to the substrate;
activating the source (34) to illuminate the substrate (22) through the lens (44), characterized in that the lens is a fresnel lens and the area of the fresnel lens is greater than the area of the frame.

## Patentansprüche

1. Vorrichtung (10) zum Belichten eines Substrates (22) mit einem darauf befindlichen photopolymerisierbaren Überzug, wobei die Vorrichtung eine solche Bauweise besitzt, daß sie einen Trägerrahmen (16) zum Unterstützung des Elements auf diesem, eine über dem Trägerrahmen angeordnete Quelle für aktinische UV-Strahlung (34) und eine zwischen der Quelle für die aktinische Strahlung (34) und dem Trägerrahmen (16) angeordnete Linse (44) besitzt, wobei die Linse (44) so beschaffen ist, daß sie die von der Quelle (34) emittierte Strahlung parallel ausrichtet und zu dem Trägerrahmen (16) hin ausrichtet, so daß die Strahlung von der Quelle auf das Element über die gesamte Oberfläche desselben hinweg im wesentlichen in senkrechter Richtung auftrifft, dadurch gekennzeichnet, daß die Linse (44) eine Fresnel-Linse mit und die Fläche der Fresnel-Linse größer ist als die Falche des Rahmens.

2. Verfahren zum Belichten eines Substrates (22) mit einem darauf befindlichen photopolymerisierbaren Überzug, umfassend die Schritte:
Befestigen des Substrats (22) an einem Ort im Strahlengang einer Quelle für aktinische UV-Strahlung (34);

Einsetzen einer Linse (44) in der Strahlengang in solcher Weise, daß die von der Quelle emittierte Strahlung parallel in einer Richtung im wesentlichen senkrecht zu dem Substrat ausgerichtet werden, kann;

Aktivieren der Quelle (34) zur Beleuchtung des Substrats (22) durch die Linse (44), dadurch gekennzeichnet, daß die Linse eine Fresnel-Linse ist und die Fläche der Fresnel-Linse größer ist als die Fläche des Rahmens

**Revendications**

1. Appareil (10) pour exposer un substrat (22) comportant un revêtement photopolymérisable, l'appareil étant du type comportant un cadre (16) de support pour soutenir l'élément sur lui, une source (34) de rayonnement actinique ultraviolet disposée au-dessus du cadre (16) de support, et une lentille (44) disposée entre la source (34) de rayonnement actinique et le cadre (16) de support, la lentille (44) étant adaptée pour collimater le rayonnement émis par la source (34) et diriger le rayonnement vers le cadre (16) de support de telle sorte que le rayonnement provenant de la source frappe l'élément dans une direction à peu près perpendiculaire à celui-ci sur la totalité de l'aire de sa surface, caractérisé en ce que la lentille (44) est une lentille de Fresnel et en ce que l'aire de la lentille de Fresnel est supérieure à l'aire du cadre.

2. Procédé pour exposer un substrat (22) comportant un revêtement photopolymérisable, comprenant les phases consistant à: monter le substrat (22) en un point du trajet du faisceau d'une source (34) de rayonnement actinique ultraviolet, à interposer une lentille (44) dans le trajet du faisceau de telle sorte que le rayonnement provenant de la source puisse être collimaté par la lentille dans une direction à peu près perpendiculaire au substrat, à activer la source (34) pour éclairer le substrat (22) à travers la lentille (44), caractérisé en ce que la lentille est une lentille de Fresnel et en ce que l'aire de la lentille de Fresnel est supérieure à l'aire du cadre.

*Fig.IA*    (PRIOR ART)

L    E   C  E    L

B

*Fig.IB*    (PRIOR ART)

L'    E'   C'  E'  L'

B

*Fig.IC*    (PRIOR ART)

L"    E"  C"  E"  L"

B

*Fig.3*

22

44B

I6M

I6S

44B

54    I6S  I6  I6M

1

## Fig.2